# EUROPEAN PATENT APPLICATION

(11) **EP 1 008 913 A1**
(43) Date of publication of application: **14.06.2000**
(21) Application number: 99124063.1
(22) Date of filing: 10.12.1999
(51) Int. Cl.: G03F 7/039

(54) **Photoresist compositions comprising itaconic anhydride polymers**

(30) Priority: 10.12.1998 US 208645
(71) Applicant: Shipley Company LLC, Marlborough, MA 01752 (US)
(72) Inventor: Barclay, George G., Jefferson Massachusetts 01522 (US); Trefonas, Peter III, Medway Massachusetts 02053 (US); Monaghan, Michael J., Carndonagh Donegal (IE)
(74) Representative: Bunke, Holger, Dr.rer.nat. Dipl.-Chem.

(57) **Abstract**

Photoresists of the invention contain a resin that comprises itaconic anhydride units, but that is substantially, essentially or completely free of itaconic acid units. It has been found that the presence of itaconic acid in a resist resin component can significantly compromise the resist's lithographic performance. Among other things, the presence of itaconic acid compromises the resolution of the developed resist relief image.

## Description

### BACKGROUND OF THE INVENTION

### 1. Field of the Invention

The present invention relates to new polymers and use of such polymers as a resin component for photoresist compositions, particularly chemically-amplified positive-acting resists. More particularly, the invention provides resins that comprise polymerized itaconic anhydride units, but that are substantially, essentially or completely free of itaconic acid units.

### 2. Background

Photoresists are photosensitive films used for transfer of images to a substrate. A coating layer of a photoresist is formed on a substrate and the photoresist layer is then exposed through a photomask to a source of activating radiation. The photomask has areas that are opaque to activating radiation and other areas that are transparent to activating radiation. Exposure to activating radiation provides a photoinduced chemical transformation of the photoresist coating to thereby transfer the pattern of the photomask to the photoresist-coated substrate. Following exposure, the photoresist is developed to provide a relief image that permits selective processing of a substrate.

A photoresist can be either positive-acting or negative-acting. For most negative-acting photoresists, those coating layer portions that are exposed to activating radiation polymerize or crosslink in a reaction between a photoactive compound and polymerizable reagents of the photoresist composition. Consequently, the exposed coating portions are rendered less soluble in a developer solution than unexposed portions. For a positive-acting photoresist, exposed portions are rendered more soluble in a developer solution while areas not exposed remain comparatively less developer soluble. In general, photoresist compositions comprise at least a resin binder component and a photoactive agent.

More recently, chemically-amplified-type resists have been increasingly employed, particularly for formation of sub-micron images and other high performance applications. Such photoresists may be negative-acting or positive-acting and generally include many crosslinking events (in the case of a negative-acting resist) or deprotection reactions (in the case of a positive-acting resist) per unit of photogenerated acid. In the case of positive chemically-amplified resists, certain cationic photoinitiators have been used to induce cleavage of certain "blocking" groups pendant from a photoresist binder, or cleavage of certain groups that comprise a photoresist binder backbone. See, for example, U.S. Patents Nos. 5,075,199; 4,968,581; 4,883,740; 4,810,613; and 4,491,628, and Canadian Patent Application 2,001,384. Upon cleavage of the blocking group through exposure of a coating layer of such a resist, a polar functional group is formed, e.g., carboxyl or imide, which results in different solubility characteristics in exposed and unexposed areas of the resist coating layer. See also R.D. Allen et al., *Proceedings of SPIE,* 2724:334-343 (1996); and P. Trefonas et al. *Proceedings of the 11*^{*th*} *International Conference on Photopolymers (Soc. Of Plastics Engineers)*, pp 44-58 (Oct. 6, 1997).

While currently available photoresists are suitable for many applications, current resists also can exhibit significant shortcomings, particularly in high performance applications such as formation of highly resolved sub-half micron and sub-quarter micron features.

Consequently, interest has increased in photoresists that can be photoimaged with short wavelength radiation, including exposure radiation of about 250 nm or less, or even about 200 nm or less, such as wavelengths of about 248 nm (provided by KrF laser) or 193 nm (provided by an ArF exposure tool). Use of such short exposure wavelengths can enable formation of smaller features. Accordingly, a photoresist that yields well-resolved images upon 248 nm or 193 nm exposure could enable formation of extremely small (e.g. sub-0.25 µm) features that respond to constant industry demands for smaller dimension circuit patterns, e.g. to provide greater circuit density and enhanced device performance.

However, many current photoresists are generally designed for imaging at relatively higher wavelengths, such as I-line (365 nm) and G-line (436 nm) exposures and are generally unsuitable for imaging at short wavelengths such as 248nm and 193 nm. In particular, prior resists exhibit poor resolution (if any image at all can be developed) upon exposure to these shorter wavelengths. Among other things, current photoresists can be highly opaque to extremely short exposure wavelengths such as 248 nm and 193 nm, thereby resulting in poorly resolved images. Efforts to enhance transparency for short wavelength exposure can negatively impact other important performance properties such as substrate adhesion, which in turn can dramatically compromise image resolution.

It thus would be desirable to have new photoresist compositions, particularly resist compositions that can be imaged at short wavelengths such as 248 nm and sub-200 nm wavelengths such as 193 nm. It would be particularly desirable to have such resist compositions that can provide high resolution relief images, particularly small features such as sub-0.25 µm images.

### SUMMARY OF THE INVENTION

The invention provides novel polymers and photoresist compositions that comprise the polymers as a resin binder component.

Photoresists of the invention contain a resin that comprises itaconic anhydride units, but that is substantially, essentially or completely free of itaconic acid units.

We have found that the presence of itaconic acid in a resist resin component can significantly compromise the resist's lithographic performance. Among other things, the presence of itaconic acid compromises the resolution of the developed resist relief image. See, for instance, the comparative results set forth in the examples which follow.

We also have found that commercial sources of itaconic anhydride uniformly contain significant amounts of itaconic acid as an impurity.

It thus has been found that purification of itaconic anhydride to remove itaconic acid prior to use of the anhydride in resin synthesis yields resin that is substantially, essentially or completely free of itaconic acid. A preferred purification is an extraction procedure, although other purification techniques also are suitable such as chromatography, precipitation, recrystallization, distillation and the like.

Generally preferred photoresists of the invention are chemically-amplified positive-acting resists that contain a resin that has itaconic anhydride units, and is substantially, essentially or completely free of itaconic acid groups. The resin typically will contain other units, such as pendant photoacid-labile units such as provided by polymerization of a suitable acrylate e.g. tertbutyl acrylate or tertbutyl methacrylate; carboxylic acid units; cyano units such as provided by polymerization of acrylonitrile or methyl acrylonitrile; aromatic units such as provided by polymerized optionally substituted styrene, vinylphenol units or optionally substituted naphthalene, alicyclic units such as provided by polymerization of vinyl olefins such as vinyl isobornyl, etc.

The invention also provides novel polymers that contain itaconic anhydride units, and that are completely, essentially or completely free of itaconic acid units. The invention also includes novel methods for synthesis of polymers containing itaconic anhydride.

The invention also provides methods for forming relief images, including methods for forming a highly resolved relief image such as a pattern of lines where each line has essentially vertical sidewalls and a line width of about 0.40 microns or less, and even a width of about 0.25, 0.20 or 0.16 microns or less. Photoresist compositions of the invention can be effectively exposed with short wavelength radiation, such as 248nm and 193 nm. The invention further provides articles of manufacture comprising substrates such as a microelectronic wafer substrate or liquid crystal display or other flat panel display substrate having coated thereon a polymer, photoresist or resist relief image of the invention. Other aspects of the invention are disclosed infra.

### DETAILED DESCRIPTION OF THE INVENTION

As discussed above, we have discovered that the presence of polymerized itaconic acid units (HO₂CCH₂C(=CH₂)CO₂H polymerized to units of -CH-(COOH)(CH₂COOH)) in a resist resin component can significantly compromise the resist's lithographic performance. Among other things, the presence of polymerized itaconic acid units compromises the resolution of the developed resist relief image.

The invention thus provides polymers that contain polymerized itaconic anhydride units, and that are completely, essentially or completely free of itaconic acid units. Suitable polymers of the invention are substantially free of the itaconic acid units, e.g. contain less than about 5 mole% or 4 mole% of itaconic acid units, as determined by proton NMR spectroscopy. Preferred polymers of the invention have itaconic anhydride units and are essentially free of itaconic acid units e.g. a polymer that has less than about 3 mole%, less than about 2 mole%, less than about 1 mole%, less than about 0.8 mole%, less than about 0.5 mole%, less than about 0.3 mole%, less than about 0.2 mole% itaconic acid as determined by proton NMR spectroscopy, or even less than about 0.1 mole% itaconic acid, as determined by proton NMR spectroscopy. Particularly preferred polymers of the invention have itaconic anhydride units and are completely free of itaconic acid units as determined by proton NMR spectroscopy.

Preferred polymers of the invention also are formed using an itaconic anhydride reagent that is of a high purity as determined by proton NMR spectroscopy, e.g. use of an itaconic anhydride reagent that contains less than about 4 wt % of itaconic acid as determined by proton NMR spectroscopy, more preferably use of itaconic anhydride reagent that has less than about 3 wt % of itaconic acid, about 2 wt% itaconic acid, about 1 wt % itaconic acid, 0.8 wt % itaconic acid, 0.5 wt % itaconic acid, 0.2 wt % itaconic acid or even less than about 0.1 wt % itaconic acid, as determined by proton NMR spectroscopy.

As discussed above, we have found that commercial sources of itaconic anhydride uniformly contain significant amounts of itaconic acid as an impurity. That is, we have found that commercially available itaconic anhydride, even where provided with a reported high purity, contains significant quantities of itaconic acid impurity, e.g. about 5 wt%, about 6 wt%, about 7 wt%, about 8 wt%, about 9 wt%, about 10 wt%, 12 wt%, 14 wt% or 15 wt% or more itaconic acid, based on the total weight of the impure itaconic anhydride sample, as determined by proton NMR spectroscopy.

Methods of the invention include purifying an itaconic anhydride reagent prior to use of that reagent to form a polymer containing itaconic anhydride units. A variety of purification may be employed. A preferred approach is extraction of the impure anhydride reagent. For instance, impure itaconic anhydride such as may be obtained from a commercial source can be mixed with an organic solvent, particularly a halogenated solvent such as chloroform or methylene chloride, preferably under an inert atmosphere such as nitrogen or argon and with agitation. Other suitable extraction solvents may include polar organic solvents, particularly halogenated solvents. After one-half, one, two or more hours of such mixing, the itaconic anhydride dissolves in the organic solvent, and the undissolved itaconic acid impurity can be filtered or otherwise removed from the organic solvent containing the itaconic anhydride. The solvent can be removed e.g. under reduced pressure to provide purified itaconic anhydride. The extraction protocol can be repeated one or more times if desired to achieve higher purity levels. See Example 1 which follows for a preferred extraction protocol.

The extraction protocol can be otherwise varied as desired. For instance, the organic solvent can be employed at a reduced temperature (e.g. 0°C) to further enhance the separation of the itaconic anhydride. The organic solvent also can be employed at an elevated temperature if desired. In general, the extraction solvent is suitably at from about 0°C to about 30°C. Solvent mixtures, which can be readily identified empirically, also can be employed as the extraction solvent. For example, a mixture of a halogenated solvent (such as CHCl₃ and CH₂Cl₂) and hexane or petroleum ether can be employed.

Chromatography also can be employed. For instance, an impure itaconic anhydride sample can be run through a bed or column of silica gel or neutral or basic alumina with a suitable eluent such as a chloroform:hexane mixture. Distillation of itaconic anhydride under reduced pressure is a further alternative, although perhaps less preferred to extraction and other procedures. Itaconic anhydride also can be purified by a precipitation procedure, where the impure itaconic anhydride is fully dissolved in a polar organic solvent (e.g. CHCl₃ at an elevated temperature, or a dipolar aprotic solvent), and then the itaconic acid impurity selectively precipitated either through cooling of the solvent mixture or addition of a second, less polar solvent such as hexane.

Preferably, itaconic anhydride will be employed in a polymer synthesis relatively promptly after being purified. For instance, preferably itaconic anhydride reagent will be purified and be used in a polymer synthesis within about 3 or 4 months after the purification is completed, more preferably within about 1-2 months after the purification is completed, or even within about 1, 2, 3 or 4 weeks or less after the purification is completed. Of course, the purified reagent can be employed even more promptly, e.g. where the itaconic anhydride is used within about 5, 4, 3, 2, or 1 days or less after purification in a polymer synthesis. However, it has been found that the purified itaconic anhydride reagent can retain a high purity for extended times upon storage in a sealed container.

For positive-acting chemically-amplified photoresist applications, polymers of the invention are typically employed that contain a photoacid labile group in addition to itaconic anhydride units.

A variety of photoacid labile groups can be employed in the polymers, including those groups identified in the above-cited patents. Preferred acid labile groups include pendant esters, particularly ester groups provided by polymerization of acrylate monomers. For instance, preferred acid-labile groups include those provided by polymerization of t-butyl acrylate and t-butyl methacrylate.

Preferred acid-labile groups also include pendant ester groups that contain an optionally substituted alkyl moiety having about 5 or more carbon atoms, with at least two branched carbon atoms, i.e. at least two secondary, tertiary or quaternary carbon atoms. The alkyl moiety can be a noncyclic or single ring alicyclic group. Suitable alkyl moieties include those that have one, two or more tertiary carbon atoms, and/or one, two or more quaternary carbons. References herein to a "secondary" carbon indicate the carbon atom has two non-hydrogen substituents (i.e. CH₂RR¹ where R and R¹ are the same or different and each is other than hydrogen); references herein to a "tertiary" carbon indicate the carbon atom has three non-hydrogen substituents (i.e. (CHRR¹R² where R, R¹ and R² are the same or different and each is other than hydrogen); and references herein to a "quaternary" carbon indicate the carbon atom has four non-hydrogen substituents (i.e. CRR¹R²R³ where R, R¹, R² and R³ are each the same or different and each is other than hydrogen). See, for instance, Morrison and Boyd, *Organic Chemistry,* particularly at page 85 (3^{rd} ed., Allyn and Bacon), for a discussion of those terms secondary, tertiary and quaternary. It also should be understood that references herein to "alkyl" with respect to such alkyl groups are inclusive of linked or branched carbon chains such as alkylidene, alkylene and the like. Additionally, for purposes of the present disclosure, the keto carbon (i.e. C=**O**) of the ester linkage is referred to herein as the "carbonyl oxygen", and the linked oxygen (i.e. C=O(**O**)) is referred to herein as the "carboxyl oxygen". It is often preferred that a quaternary carbon is directly linked (i.e. covalently linked with no other interposed atoms) to the ester carboxyl oxygen, as is depicted in the above structure. Preferred alkyl ester groups of polymers of the invention contain only saturated carbon atoms. Thus, e.g., in this preferred aspect of the invention, the groups R, R¹, R², R³ of the above formulae for secondary, tertiary and quaternary carbons of alkyl ester groups (i.e. the formulae CH₂RR¹, CHRR¹R², CRR¹R²R³) are each saturated alkyl, typically C₁₋₁₀ alkyl, more typically C₁₋₆ alkyl, still more typically alkyl having 1, 2, 3 or 4 carbons. Preferred alkyl moieties include those having 1 quaternary carbon linked to the carboxyl oxygen atom of the ester monomer and ≥1 additional tertiary or quaternary carbon atoms and not more than a one single ring alicyclic group. Additional preferred alkyl moieties include those having 1 quaternary carbon linked to the carboxyl oxygen atom of the ester monomer and ≥1 additional secondary carbon atoms and no more than one ring alicyclic groups. Optimally, the ester group will contain only carbon and hydrogen atoms and be free of double or triple bonds. More preferred alkyl moieties include those having one quaternary carbon linked to the carboxyl oxygen atom of the ester monomer and ≥1 additional quaternary or tertiary carbon atoms and not more than a one single ring alicyclic group, although other groups also will be preferred such as 2,2,3,4,4-pentamethyl-3-pentyl methacrylate {or 2,2,3,4,4-pentamethyl-3-pentyl acrylate} and 2,3,4-trimethyl-3-pentyl methacrylate {or 2,3,4-trimethyl-3-pentyl acrylate}. Optimally, the ester group will contain solely carbon and hydrogen atoms and be free of double or triple bonds. These ester groups, and synthesis of same, have also been disclosed in copending and commonly assigned U.S. application serial number 09/143,462, filed August 28, 1998. Specifically preferred ester groups include those of the following structures, where Y in those structures is either hydrogen or methyl.

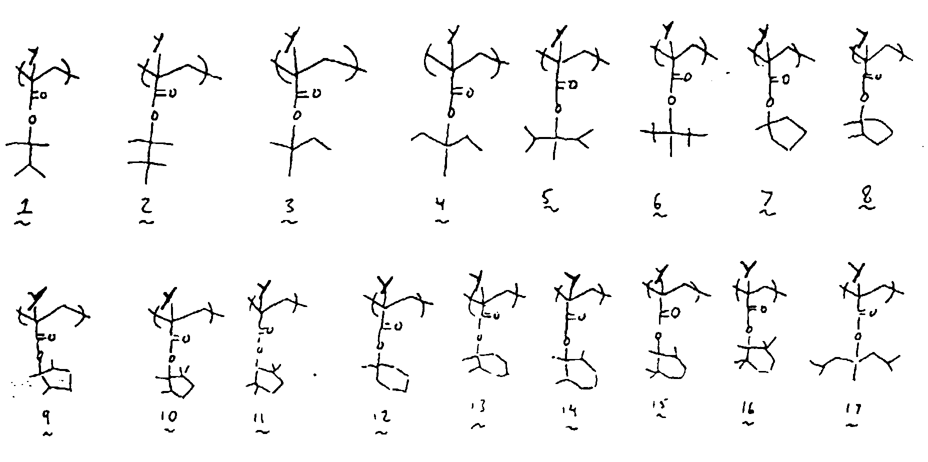

Polymers of the invention may contain units in addition to the alkyl esters units described above. For example, polymers may contain additional photoacid-labile groups such as pendant esters such as those of the formula ―WC(=O)OR⁵, wherein W is a linker such as a chemical bond, an alkylene particularly C₁₋₃ alkylene, or carbocyclic aryl such as phenyl, or aryloxy such as phenoxy, and R⁵ is a suitable ester moiety such as an optionally substituted alkyl (including cycloalkyl) suitably having from 1 to about 20 carbons, more preferably about 4 to about 12 carbons, but without a noncyclic or single ring alkyl group having 5 or more carbons and two or more secondary, tertiary or quaternary carbons; optionally substituted alkenyl (including cycloalkenyl) group suitably having from 2 to about 20 carbons, more preferably about 4 to about 12 carbons; optionally substituted alkynyl group suitably having from 2 to about 20 carbons, more preferably about 4 to about 12 carbons; optionally substituted alkoxy group suitably having from 1 to about 20 carbons, more preferably 2 to about 12 carbons; or a heteroalicyclic group that contains one or more N, O or S atoms and one or more rings having from 4 to about 8 ring members such as tetrahydrofuranyl, thienyl, tetrahydropyranyl, morpholino and the like. Specifically preferred R⁵ groups include e.g. t-butyl, tetrahydropyran, ethoxyethyl, or an alicyclic group including bridged groups such as such as adamantyl including 2-methyl-2-adamantyl, norbornyl, isobornyl and the like.

Polymers of the invention optionally may contain other groups that contribute to aqueous developability of a photoresist. For example, preferred polymer groups that contribute to aqueous developability contain carboxy or hydroxy moieties such as may be provided by condensation of vinylaryl such as vinylphenol which may be provided by condensation of vinylphenol, acrylic acid, methacrylic acid, 2-hydroxyethylmethacrylate, or other hydrophilic monomers.

Other optional polymer units include those that may be provided by condensation of a vinyl alicyclic group, e.g. 2-adamantyl-2-methyl methacrylate, isobornyl methacrylate and the like, or a non-cyclic alkyl group such as t-butyl methacrylate and the like, or a vinyl nitrile such as condensation of methacrylonitrile to provide pendant cyano groups. Pendant cyano, acid (COOH), and/or alicyclic groups, such as those mentioned above, are generally preferred additional units of polymers of the invention.

Some particularly preferred polymers of the invention include units of the following Formula I and are substantially, essentially or completely free of itaconic acid units.

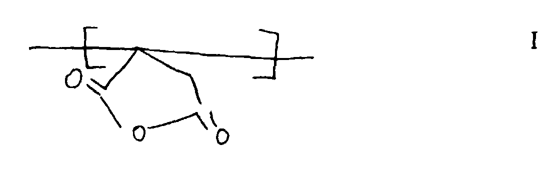

As discussed above, preferred polymers of the invention include photoacid labile units in addition to itaconic anhydride units, such as polymers that include units of the following Formula II: 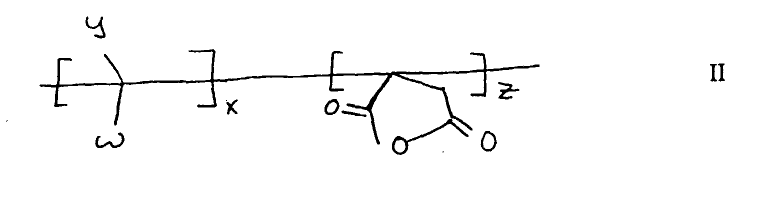 wherein in the above in the above Formula II, W is a pendant photoacid labile group such as provided by condensation of an acrylate monomer as discussed above,
x and z are mole fractions or percents of the respective units based on total units of the polymer, and preferably x is from about 1 to 80 mole percent, more typically 5 to about 50 mole percent; and z is from about 1 to 50 mole percent, more typically 1 to about 40 mole percent;
and Y is hydrogen or optionally substituted alkyl, preferably hydrogen or C₁₋₄ alkyl such as methyl, and where the polymer is substantially, essentially or completely free of itaconic acid units

Particularly preferred polymers of the invention include the following Formulae III and IV: 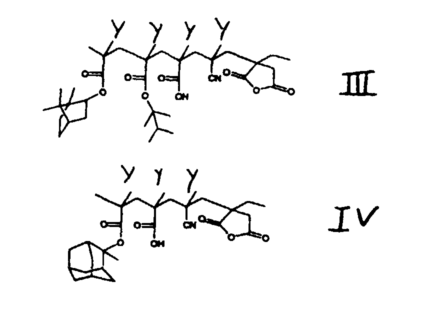 wherein in those Formulae III and IV, each Y is independently hydrogen or methyl, and where each polymer is substantially, essentially or completely free of itaconic acid units.

For use in photoresists to be imaged at 193 nm and other sub-200 nm wavelengths, preferably a polymer of the invention will be substantially free of any phenyl or other aromatic groups. For example, preferred polymers contain less than about 5 mole percent aromatic groups, more preferably less than about 1 mole percent aromatic groups, more preferably less than about 0.1, 0.02, 0.04 and 0.08 mole percent aromatic groups and still more preferably less than about 0.01 mole percent aromatic groups. Particularly preferred polymers are completely free of aromatic groups. Aromatic groups can be highly absorbing of sub-200 nm radiation and thus are undesirable for polymers used in photoresists imaged with such short wavelength radiation. The above polymers of Formulae III and IV are particularly suitable for sub-200 nm exposure applications, including 193 nm applications.

Polymers of the invention can be prepared by a variety of methods. One suitable method is free radical polymerization, e.g., by reaction of itaconic anhydride and selected other monomers to provide the various units as discussed above in the presence of a radical initiator under an inert atmosphere (e.g., N₂ or argon) and at elevated temperatures such as about 70°C or greater, although reaction temperatures may vary depending on the reactivity of the particular reagents employed and the boiling point of the reaction solvent (if a solvent is employed). Suitable reaction solvents include e.g. tetrahydrofuran, ethyl lactate and the like. Suitable reaction temperatures for any particular system can be readily determined empirically by those skilled in the art based on the present disclosure. A variety of free radical initiators may be employed. For example, azo compounds may be employed such as azo-bis-2,4-dimethylpentanenitrile. Peroxides, peresters, peracids and persulfates also could be employed. See Example 2 which follows for exemplary reagents and conditions for synthesis of polymers of the invention.

As discussed, various moieties may be optionally substituted. A "substituted" substituent may be substituted at one or more available positions, typically 1, 2, or 3 positions by one or more suitable groups such as e.g. halogen (particularly F, Cl or Br); C₁₋₈ alkyl; C₁₋₈ alkoxy; C₂₋₈ alkenyl; C₂₋₈ alkynyl; hydroxyl; alkanoyl such as a C₁₋₆ alkanoyl e.g. acyl and the like; etc

Polymers also may be formed by modification of preformed resins. For example, a preformed poly(vinylphenol) polymer or copolymer that contains itaconic anhydride may have appropriate ester units (e.g., via acidic condensation of acrylate monomers) grafted onto the phenolic oxygens. A preferred polymer for such condensation is a copolymer of phenol units and nonaromatic alcohol as disclosed in U.S. Patents 5,128,232 and 5,340,696 to Thackeray et al.

Preferably a polymer of the invention will have a weight average molecular weight (M_{w}) of 1,000 to about 100,000, more preferably about 2,000 to about 30,000, still more preferably from about 2,000 to 15,000 or 20,000, with a molecular weight distribution (M_{w}/Mₙ) of about 3 or less, more preferably a molecular weight distribution of about 2 or less. Molecular weights (either M_{w} or Mₙ₎ of the polymers of the invention are suitably determined by gel permeation chromatography.

Polymers of the invention typically will contain at least about 0.5 or about 1 mole percent of itaconic anhydride units, more typically at least about 3, 4 or 5 mole percent of itaconic anhydride units, still more typically about 8, 10, 12, 15 or 20 mole percent of itaconic anhydride units.

Polymers of the invention used in positive-acting chemically-amplified photoresist formulations should contain a sufficient amount of photogenerated acid labile ester groups to enable formation of resist relief images as desired. For instance, suitable amount of such acid labile ester groups will be at least 1 mole percent of total units of the polymer, more preferably about 2 to 50 mole percent, still more typically about 3 to 30 or 40 mole percent of total polymer units. See the examples which follow for exemplary preferred polymers.

Photoresists of the invention in general comprise a photoactive component and a resin binder component that comprises a polymer as described above.

The resin component should be used in an amount sufficient to render a coating layer of the resist developable with an aqueous alkaline developer.

The resist compositions of the invention also comprise a photoactive component that typically is a photoacid generator (i.e. "PAG") and that is suitably employed in an amount sufficient to generate a latent image in a coating layer of the resist upon exposure to activating radiation. Preferred PAGs for imaging at 193 nm and 248 nm imaging include imidosulfonates such as compounds of the following formula: 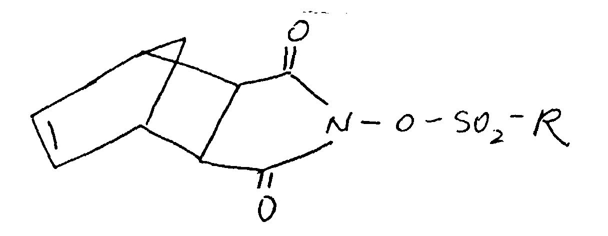 wherein R is camphor, adamantane, alkyl (e.g. C₁₋₁₂ alkyl) and perfluoroalkyl such as perfluoro(C₁₋₁₂alkyl), particularly perfluorooctanesulfonate, perfluorononanesulfonate and the like. A specifically preferred PAG is N-[(perfluorooctanesulfonyl)oxy]-5-norbornene-2,3-dicarboximide.

Sulfonate compounds are also suitable PAGs, particularly sulfonate salts. Two suitable agents for 193 nm and 248 nm imaging are the following PAGS 1 and 2:

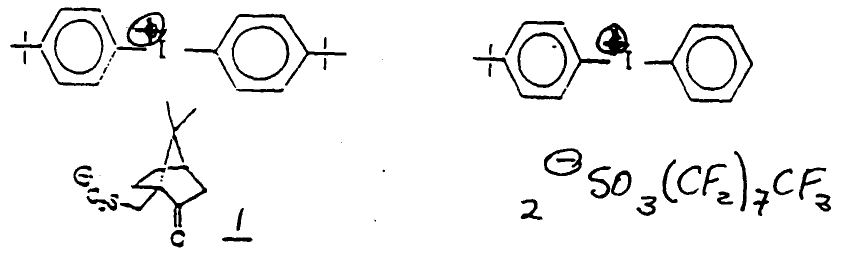

Such sulfonate compounds can be prepared as disclosed in European Patent Application 96118111.2 (publication number 0783136), which details the synthesis of above PAG 1. Briefly, PAG 1 can be prepared by reaction of a mixture of potassium iodate, t-butylbenzene and acetic anhydride with sulfuric acid added dropwise to the mixture with ice-bath cooling. The reaction mixture is then stirred at room temperature for approximately 22 hours, water added with cooling to about 5-10°C and then washing with hexane. The aqueous solution of diaryliodium hydrogensulfate is then cooled to about 5-10°C and then camphorsulfonic acid is added followed by neutralization with ammonium hydroxide.

Also suitable are the above two iodonium compounds complexed with anions other than the above-depicted camphorsulfonate groups. In particular, preferred anions include those of the formula RSO₃⁻ where R is adamantane, alkyl (e.g. C₁₋₁₂ alkyl) and perfluoroalkyl such as perfluoro (C₁₋₁₂alkyl), particularly perfluorooctanesulfonate, perfluorobutanesulfonate and the like.

It also may be desirable to employ a mixture of different PAGS in a single photoresist composition. It particular, it is preferred to use a blend of ionic and non-ionic PAGs, such as an imidosulfonate non-ionic PAG identified above blended with one of the above ionic sulfonate salts 1 and 2. See also copending and commonly assigned U.S. application 09/150,965, filed September 10, 1998, for further discussion of such ionic and non-ionic PAG blends.

A preferred optional additive of resists of the invention is an added base, particularly tetrabutylammonium hydroxide (TBAH), or tetrabutylammonium lactate, which can enhance resolution of a developed resist relief image. For resists imaged at 193 nm, a preferred added base is a hindered amine such as diazabicyclo undecene or diazabicyclononene. The added base is suitably used in relatively small amounts, e.g. about 0.03 to 5 percent by weight relative to the total solids.

Photoresists of the invention also may contain other optional materials. For example, other optional additives include anti-striation agents, plasticizers, speed enhancers, etc. Such optional additives typically will be present in minor concentrations in a photoresist composition except for fillers and dyes which may be present in relatively large concentrations, e.g., in amounts of from about 5 to 30 percent by weight of the total weight of a resist's dry components.

The compositions of the invention can be readily prepared by those skilled in the art. For example, a photoresist composition of the invention can be prepared by dissolving the components of the photoresist in a suitable solvent such as, for example, ethyl lactate, ethylene glycol monomethyl ether, ethylene glycol monomethyl ether acetate, propylene glycol monomethyl ether; propylene glycol monomethyl ether acetate and 3-ethoxyethyl propionate. Typically, the solids content of the composition varies between about 5 and 35 percent by weight of the total weight of the photoresist composition. The resin binder and photoactive components should be present in amounts sufficient to provide a film coating layer and formation of good quality latent and relief images. See the examples which follow for exemplary preferred amounts of resist components.

The compositions of the invention are used in accordance with generally known procedures. The liquid coating compositions of the invention are applied to a substrate such as by spinning, dipping, roller coating or other conventional coating technique. When spin coating, the solids content of the coating solution can be adjusted to provide a desired film thickness based upon the specific spinning equipment utilized, the viscosity of the solution, the speed of the spinner and the amount of time allowed for spinning.

The resist compositions of the invention are suitably applied to substrates conventionally used in processes involving coating with photoresists. For example, the composition may be applied over silicon wafers or silicon wafers coated with silicon dioxide for the production of microprocessors and other integrated circuit components. Aluminum-aluminum oxide, gallium arsenide, ceramic, quartz, copper, glass substrates and the like are also suitably employed.

Following coating of the photoresist onto a surface, it is dried by heating to remove the solvent until preferably the photoresist coating is tack free. Thereafter, it is imaged through a mask in conventional manner. The exposure is sufficient to effectively activate the photoactive component of the photoresist system to produce a patterned image in the resist coating layer and, more specifically, the exposure energy typically ranges from about 1 to 100 mJ/cm², dependent upon the exposure tool and the components of the photoresist composition.

As discussed above, coating layers of the resist compositions of the invention are preferably photoactivated by a short exposure wavelength, particularly a sub-300 and sub-200 nm exposure wavelength. Particularly preferred exposure wavelengths include 193 nm and 248 nm. However, the resist compositions of the invention also may be suitably imaged at higher wavelengths. For example, a resin of the invention can be formulated with an appropriate PAG and used as a chemically-amplified positive I-line resist, i.e. a resist imaged at about 365 nm.

Following exposure, the film layer of the composition is preferably baked at temperatures ranging from about 70°C to about 160°C. Thereafter, the film is developed. The exposed resist film is rendered positive working by employing a polar developer, preferably an aqueous based developer such as quaternary ammonium hydroxide solutions such as a tetra-alkyl ammonium hydroxide solution; various amine solutions preferably a 0.26 N tetramethylammonium hydroxide, such as ethyl amine, n-propyl amine, diethyl amine, di-n-propyl amine, triethyl amine, or methyldiethyl amine; alcohol amines such as diethanol amine or triethanol amine; cyclic amines such as pyrrole, pyridine, etc. In general, development is in accordance with procedures recognized in the art.

Following development of the photoresist coating over the substrate, the developed substrate may be selectively processed on those areas bared of resist, for example by chemically etching or plating substrate areas bared of resist in accordance with procedures known in the art. For the manufacture of microelectronic substrates, e.g., the manufacture of silicon dioxide wafers, suitable etchants include a gas etchant, e.g. a chlorine or fluorine-based etchant such a Cl₂ or CF₄/CHF₃ etchant applied as a plasma stream. After such processing, resist may be removed from the processed substrate using known stripping procedures.

All documents mentioned herein are incorporated herein by reference. The following non-limiting examples are illustrative of the invention.

### Example 1. Purification of Itaconic Anhydride

Itaconic anhydride (100g, 95% pure from Aldrich, 85% by NMR) was slurried in chloroform (500ml), under N₂ with stirring for 2 hours. The slurry was then filtered, and the impurity (itaconic acid) was insoluble in chloroform and was filtered off during filtration. The eluent from the filtration containing the pure itaconic anhydride was then concentrated using a rotary evaporator. The resulting white solid was dried under vacuum overnight. The purity of the itaconic anhydride was checked by ¹H NMR and found to be greater than 98%. Yield = 80.2g (80%).

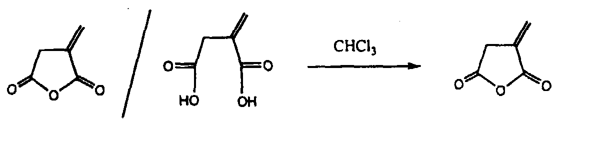

### Example 2: Synthesis of a Preferred Polymer

A preferred polymer of the invention was prepared as follows. Isobornyl methacrylate (48.8g, 0.217 mol), t-butyl methacrylate (20.5g, 0.144 mol), methacrylonitrile (9.7g, 0.144 mol), purified itaconic anhydride (12.2g, 0.109 mol) (the itaconic anhydride was purified as described in Example 1 above), and methacrylic acid (9.3g, 0.108 mol) were dissolved in 175 ml of tetrahydrofuran. The reaction solution was then deoxygenated by gently bubbling a stream of N₂ through the stirring solution for 20 minutes, and then placing it under a blanket of N₂. The polymerization solution was then brought to a gentle reflux. 2,2-Azo-bis-2,4-dimethylpentanenitrile 8.95g (0.0361 mol) dissolved in 25 ml of tetrahydrofuran, was then added to the gently refluxing mixture over 5 minutes. The polymerization was then refluxed with stirring for 16 hours.

Upon completion of the polymerization the reaction was then cooled to room temperature, and the polymer was isolated by precipitation into hexanes (3000 mL). The polymer was then filtered and washed well with hexanes. Finally the polymer was dried in a vacuum oven at 60° C for 24 hours. Yield 80g (80% of theory), M_{w} 5283, Mₙ 3473, T_{g} = 129°C and T_{d} = 210°C.

### Example 3 (comparative) Resist Polymer Containing Itaconic Acid

To demonstrate that itaconic acid is detrimentally to resist performance, itaconic acid was deliberately incorporated into a polymer.

A polymer was prepared that has the following units in the specified molar ratios: isobornylmethacrylate (30 mole percent):tert-butylmethacrylate (30 mole percent):metylacyrlonitrile (11 mole percent): itaconic anhydride (21 mole percent); itaconic acid (8mole percent). That polymer is referred to below as the Example 3 Comparative Polymer. The polymer was prepared by the general procedures of Example 2 above.

A photoresist was prepared as follows and is referred to herein as the "Example 3 Comparative Resist". The following components were admixed in a solvent of propylene glycolmethyl ether acetate at 15 weight % total solids: Example 3 Comparative Polymer in an amount of the balance of total solids; photoacid generator of N-[1-perfluoroctanesulfonyloxy]-5-norbornene-2,3-dicaroximide at 5 weight % of total solids; Proton Sponge at 0.06 weight percent of total solids; and Silwet 7604 (Dow Corning Co., USA) at 0.1 weight percent of total solids.

The Example 3 Comparative Resist was spin coated onto a silicon wafer substrate that was overcoated with an antireflective coating layer. The coated wafer was then soft-baked at 125°C on a vacuum hotplate for 60 seconds to provide a resist coating layer thickness of approximately 4100 angstroms. The resist coating layer then was exposed to patterned radiation having a wavelength of 193 nm, post-exposure baked at 155°C, and then developed with 0.26N tetrabutyl ammonium hydroxide aqueous solution for 40 seconds.

The Example 3 Comparative Resist had very poor performance with resolution limited to very poor 0.18 micron 1:1 line:space features at a minimum exposure dose of 82 mJ/cm² with extensive microbridging and gelling between lines, and line top peeling.

### Example 4. Polymers Containing Purified and Impure Itaconic Anhydride and Photoresists Containing Such Polymers

Two polymers were prepared. The first polymer (referred to below as "Polymer One") was prepared using a commercially available (Aldrich) source of itaconic anhydride without any purification of the anhydride reagent prior to the polymerization reaction. The second polymer (referred to below as "Polymer Two") was prepared under the exact same conditions and using the same reagents as Polymer One, but where the commercial itaconic anhydride had been purified by extraction as described in Example 1 prior to the polymerization reaction. The polymers had the following compositions:
Polymer One: isobornyl methacrylate (31 mole%): tert-butyl methacrylate (20 mole %): methylacrylic acid (12 mole %); methylacrylonitrile (14 mole percent): itaconic anhydride (unpurified) (23 mole percent)
Polymer Two: isobornyl methacrylate (31 mole%): tert-butyl methacrylate (20 mole %): methylacrylic acid (12 mole %); methylacrylonitrile (14 mole percent): itaconic anhydride (purified) (23 mole percent)

A photoresist referred to herein as Resist One was prepared as followed. The following components were admixed in a solvent of propylene glycolmethyl ether acetate at 15 weight % total solids: Polymer One in an amount of the balance of the total solids; photoacid generator of N-[1-perfluoroctanesulfonyloxy]-5-norbornene-2,3-dicaroximide at 5 weight % of total solids; Proton Sponge at 0.06 weight percent of total solids; and Silwet 7604 (Dow Corning Co., USA) at 0.1 weight percent of total solids.

A photoresist referred to herein as Resist Two prepared as followed. The following components were admixed in a solvent of propylene glycolmethyl ether acetate at 15 weight % total solids: Polymer Two an amount of the balance of the total solids; photoacid generator of N-[1-perfluoroctanesulfonyloxy]-5-norbornene-2,3-dicaroximide at 5 weight % of total solids; Proton Sponge at 0.06 weight percent of total solids; and Silwet 7604 (Dow Corning Co., USA) at 0.1 weight percent of total solids.

Each of Resist One and Resist Two were spin coated onto separate silicon wafer substrate that were overcoated with an antireflective coating layer. The coated wafers were then soft-baked at 125°C on a vacuum hotplate for 60 seconds to provide a resist coating layer thickness of approximately 5200 angstroms. The resist coating layers then were exposed to patterned radiation having a wavelength of 193 nm, post-exposure baked at 155°C, and then developed with 0.26N tetrabutyl ammonium hydroxide aqueous solution for 90 seconds.

Resist Two provided significantly better resolved 0.15 micron line:space features than Resist One. In particular, Resist Two provide lines with smoother sidewalls and flatter tops indicating less gelling and swelling by the resist, relative to the features imaged with Resist One. Resist Two also yielded improved iso/dense bias with less erosion of the isolated feature at equivalent dose to the dense features, relative to Resist One.

The foregoing description of the invention is merely illustrative thereof, and it is understood that variations and modification can be made without departing from the spirit or scope of the invention as set forth in the following claims.

## Claims

1. A photoresist composition comprising a photoactive component and a resin, the resin comprising itaconic anhydride units and being at least essentially free of itaconic acid units.

2. The photoresist of claim 1 wherein the resin is formed from itaconic anhydride that has been purified prior to synthesis of the polymer.

3. The photoresist of claim 2 wherein the itaconic anhydride has been purified by extraction, chromatography, recrystallization, precipitation or distillation.

4. The photoresist composition of any one of claims 1 to 3 wherein the resin has less than about 4 mole percent of itaconic acid units.

5. The photoresist composition of claim 4 wherein the resin is completely free of itaconic acid units.

6. The photoresist composition of any one of claims 1 to 5 wherein the photoresist is a chemically-amplified photoresist.

7. The photoresist composition of any one of claims 1 to 6 wherein the resin comprises photoacid-labile ester units.

8. A method for forming a photoresist composition according to any one of claims 1 to 7, comprising:
(a) purifying itaconic anhydride and forming a resin with the purified itaconic anhydride, the resin comprising itaconic anhydride units;
(b) admixing the resin with a photoactive component to form a photoresist.

9. The method of claim 8 wherein the resin is purified by extraction, chromatography, recrystallization, precipitation or distillation.

10. The method of claim 8 or claim 9 wherein the resin has less than about 4 mole percent itaconic acid units.

11. The method of any one of claims 8 to 10 further comprising applying a coating layer of the photoresist on a substrate, exposing the photoresist coating layer to patterned activating radiation, and developing the exposed photoresist coating layer to form a photoresist relief image.

12. The method of claim 11 wherein the photoresist is exposed to activating radiation that has a wavelength of 248 nm or 193 nm.
